# EUROPEAN PATENT SPECIFICATION

(11) **EP 1 139 574 B1**
(45) Date of publication and mention of the grant of the patent: **29.12.2004**
(21) Application number: 01302565.5
(22) Date of filing: 20.03.2001
(51) Int. Cl.: H04B 1/16, G01S 1/04, H03J 1/00

(54) **Receiver for a mobile unit**
Mobile Empfängereinheit
Unité de récepteur mobile

(30) Priority: 29.03.2000 JP 2000092152
(43) Date of publication of application: 04.10.2001
(73) Proprietor: Pioneer Corporation, Meguro-ku, Tokyo (JP)
(72) Inventor: Odashima, Masahiro, c/o Pioneer Corporation, Kawagoe-shi, Saitama (JP); Yamanaka, Tadamasa, c/o Pioneer Corporation, Kawagoe-shi, Saitama (JP); Sakuma, Koji, c/o Pioneer Corporation, Kawagoe-shi, Saitama (JP)
(74) Representative: Haley, Stephen

(56) References cited:
- EP-A- 0 813 302
- EP-A- 0 874 344
- EP-A- 0 964 514
- EP-A- 1 209 863
- US-A- 4 987 605
- US-A- 5 393 713
- US-A- 5 537 674
- US-A- 6 011 973

## Description

### 1. Field of the Invention

The present invention relates to a receiver for mobile unit which is mounted in mobile units such as a vehicle or a ship and receives radio waves sent from a broadcast station.

### 2. Description of the Related Art

In mobile units such as a vehicle or a ship, the present position changes momentarily, so that various functions intended to be able to simply select stations which a user can receive are mounted in a receiver which is mounted in the mobile units and receives radiobroadcast.

For example, there is a seek function for tuning the receiver to a station having a predetermined electric field strength in the present position by one operation of an UP/DOWN key, or an automatic station-selection storage function for automatically tuning the receiver to plural stations having a predetermined electric field strength in the present position and automatically storing a frequency of the tunable stations in a preset key.

A frequency band of a radio wave used by a broadcast station sending the radio wave or a frequency which the broadcast station can use in the frequency band is defined by a country or a region.

In the case of manufacturing a receiver, it is necessary to individually set a frequency band which the receiver can use or a step width of a frequency at the time of retrieving stations tunable by the seek function and the automatic station-selection storage function according to a frequency band of a country or a region in which the receiver is used or a frequency which a broadcast station can use, so that production efficiency does not improve.

Therefore, an object of the present invention is solve the above problem with the conventional receiver.

In order to achieve the above object, according to the present invention, there is provided a receiver for mobile unit, comprising:
storage means for storing a region and a frequency band of an available radio wave of the region; and
control means for detecting a region in which a mobile unit is located from the present position detected by present position measuring means for measuring the present position of the mobile unit and setting a receiving frequency band of the receiver based on the detected result.

Further, according to the present invention, in the receiver for mobile unit of the invention, a frequency step width corresponding to the region is stored in the storage means and the control means sets a frequency step width of the receiver based on the detected result.

**In the Drawings;**
Fig. 1 is a block diagram of a receiver for mobile unit of an embodiment of the invention;
Fig. 2 is a storage table of frequency data stored in the receiver for mobile unit of the embodiment of the invention; and
Fig. 3 is a flowchart showing operating control in the receiver for mobile unit of the embodiment of the invention.

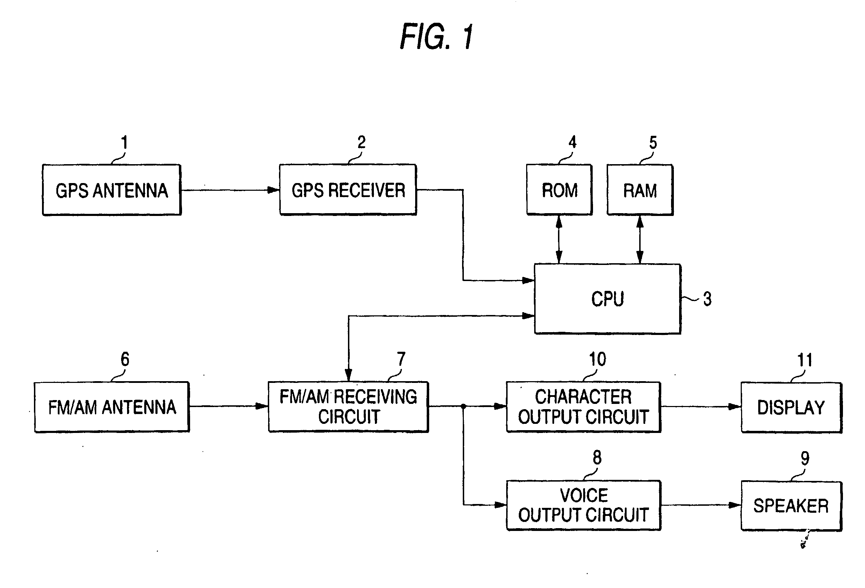

An embodiment preferable in the invention will be described in detail using Figs. 1 to 3 below. Incidentally, in the embodiment described below, a vehicle is applied as a mobile unit and a receiver for vehicle mounted in this mobile unit is shown.

Fig. 1 shows a block diagram of a receiver mounted in a vehicle. In Fig. 1, numeral 1 is a GPS antenna in a GPS (Global Positioning System), and numeral 2 is a GPS receiver.

The GPS receiver 2 can receive radio waves sent from a GPS satellite located in an orbit with an orbital altitude of 20183 km through the GPS antenna 1 and measure the present position of the vehicle as information about latitude, longitude and altitude.

A CPU 3 acting as control means is a controller for administering basic control of the whole receiver for vehicle, and controls each component based on a control program stored in ROM 4. Each of the information about the latitude, longitude and altitude indicating the momentarily changing present positions of the vehicle measured by the GPS receiver 2 is stored in RAM 5 through the CPU 3.

Numeral 6 is an FM/AM antenna which is intended for receiving a broadcast signal sent from an FM station or an AM station. Numeral 7 is an FM/AM receiving circuit which is intended for converting the broadcast signal received by the FM/AM antenna 6 into an intermediate frequency signal and comprises a front end providing a tuning part, a high-frequency amplifier and a frequency converter, and a PLL circuit for outputting a frequency signal in response to a station-selection frequency.

Numeral 8 is a voice output circuit for demodulating a voice signal portion included in the broadcast signal, and the voice signal demodulated herein is outputted as a voice from a speaker 9. Also, numeral 10 is a character output circuit for demodulating a character signal portion included in the broadcast signal, and the character signal demodulated herein is displayed on a display 11.

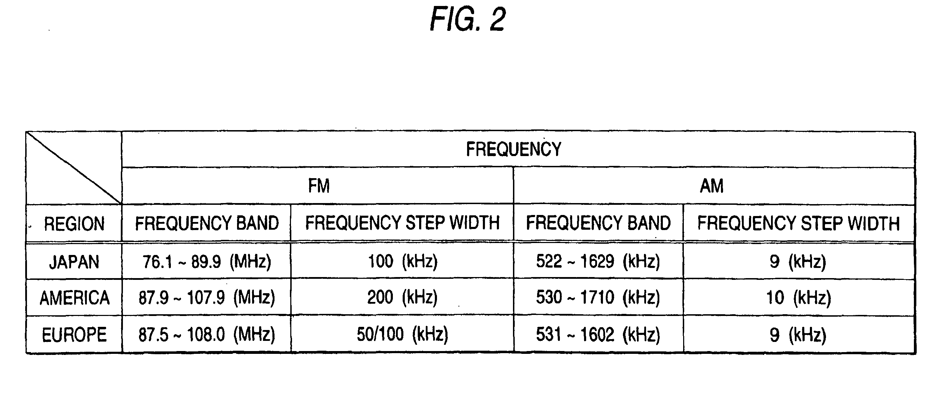

Fig. 2 is frequency data stored in the ROM 4. A storage table of regions, receiving frequency bands and frequency step widths of the regions is shown. As shown in Fig. 2, as data for Japan, frequency band data of an FM band is stored as 76.1 MHz to 89.9 MHz and frequency step data is stored as 100 kHz.

Also, frequency band data of an AM band is stored as 522 kHz to 1629 kHz and frequency step data is stored as 9 kHz. Therefore, when the vehicle resides in Japan, namely, under conditions that this receiver for vehicle is used in Japan, each of the frequency band data and the frequency step data of the FM band and the AM band is read from the ROM 4 by the CPU 3 and is set to the FM/AM receiving circuit 7.

Thus, when the automatic station-selection storage function described above in this receiver for vehicle is started using the FM band as a target, in the FM/AM receiving circuit 7, tuning operations are performed in steps of 100 kHz using the frequency band of 76.1 MHz to 89.9 MHz as a target and the top-five stations with the good receiving state (strong electric field strength) among the tuned stations are allocated to five preset keys.

Similarly, when the automatic station-selection storage function is started using the AM band as a target, in the FM/AM receiving circuit 7, tuning operations are performed in steps of 9 kHz using the frequency band of 522 kHz to 1629 kHz as a target and the top-five stations with the good receiving state (strong electric field strength) among the tuned stations are allocated to five preset keys.

On the other hand, as shown in Fig. 2, as data for America, frequency band data of an FM band is stored as 87.9 MHz to 107.9 MHz and frequency step data is stored as 200 kHz. Also, frequency band data of an AM band is stored as 530 kHz to 1710 kHz and frequency step data is stored as 10 kHz. Therefore, when the vehicle resides in America, namely, under conditions that this receiver for vehicle is used in America, each of the frequency band data and the frequency step data of the FM band and the AM band is read from the ROM 4 by the CPU 3 and is set to the FM/AM receiving circuit 7.

This control for reading each of the frequency band data and the frequency step data of the FM band and the AM band from the ROM 4 by the CPU 3 and setting the data to the FM/AM receiving circuit 7 is performed based on the present position of the vehicle measured by the GPS receiver 2.

In this manner, by automatically setting the frequency step at 100 kHz when this receiver for vehicle is used in Japan and the frequency step at 200 kHz when this receiver for vehicle is used in America, for example, in the case of performing the automatic station-selection storage function in America, all the tuning operations of the frequency band are completed in steps of 200 kHz, so that the operations are completed in a short time compared with the case of performing all the tuning operations of the frequency band in steps of 100 kHz.

Incidentally, the reason why the frequency step of Japan is set at 100 kHz and the frequency step of America is set at 200 kHz is because frequencies available by each adjacent station need to be shifted by 100 kHz in Japan (available frequencies of a station may be used every 100 kHz) while frequencies available by each adjacent station need to be shifted by 200 kHz in America.

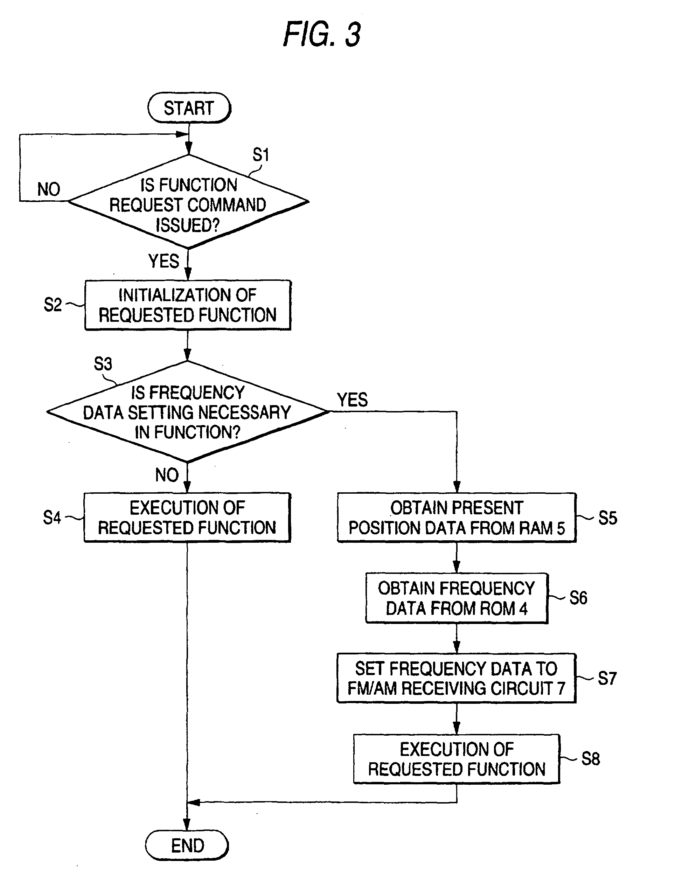

Next, control operations of the CPU 3 acting as control means will be described based on Fig. 3. In this control operations, a receiver for vehicle is controlled based on a control program stored in the ROM 4.

First, it is determined whether or not a function request command is issued by an operation through a user of this receiver for vehicle (step S1). If it is determined that the function request command is not issued (no), an operation returns to this step S1 again to become a standby state.

If it is determined that the function request command is issued (yes), initialization of a requested function is started (step S2). Next, it is determined whether or not frequency data is necessary in the function requested at the time of setting operation (step S3).

If it is determined that the frequency data is not necessary (no), a setting of the requested function is completed and an operation proceeds to execution of the function (step S4), and control based on this program is ended.

On the other hand, if it is determined that the frequency data is necessary (yes), the newest present position data of the vehicle is obtained from the RAM 5 (step S5). As described above, the present position data comprising information about the latitude, longitude and altitude measured by the GPS receiver 2 is stored in this RAM 5.

Next, the CPU 3 determines a region in which the vehicle is located from the present position data obtained. Then, each of frequency band data and frequency step data of an FM band and an AM band corresponding to the determined region is read from the ROM 4 (step S6).

Subsequently, the frequency band data and the frequency step data read from the ROM 4 are set to the FM/AM receiving circuit 7 (step S7), and a setting of the requested function is completed and an operation proceeds to execution of the function (step S8), and control based on this program is ended.

In the embodiment described above, the receiver for vehicle has been described, but by forming a similar configuration also in a receiver for ship capable of moving a wide region, larger effect can be obtained.

Also, the GPS receiver 2 has been applied as measuring means for measuring the present position, but present position data may be obtained on the basis of base data from a base to which a portable telephone terminal is connected using a portable telephone system.

Also, it has been constructed so that frequency data comprising the frequency band data and the frequency step data is previously stored in the ROM 4, but using a portable telephone system, the frequency band data and the frequency step data maybe received from a base to which a portable telephone terminal is presently connected and this received data may be stored in the RAM 5 to execute control operations. Further, a broadcast station every each region may send the frequency band data and the frequency step data and this may be received and stored in the RAM 5 to execute control operations.

Also, the example of the seek function or the automatic station-selection storage function has been shown as a function of the receiver in which a setting of frequency data is necessary, but the function is not limited to this and the invention can be applied to all the functions using the frequency band data and the frequency step data.

In a receiver for mobile unit of the invention, a region in which a mobile unit is located is detected from the present position of the mobile unit and a receiving frequency band of the receiver is set based on the detected result, so that there is no need to preset the receiving frequency band of the receiver every region at the time of manufacture.
Fig. 1
   - 1: GPS Antenna
   - 2: GPS Receiver
   - 3: CPU
   - 4: ROM
   - 5: RAM
   - 6: FM/AM Antenna
   - 7: FM/AM Receiving Circuit
   - 8: Voice Output Circuit
   - 9: Speaker
   - 10: Character Output Circuit
   - 11: Display
Fig. 2
   - A1: Frequency
   - A2: Region
   - A3: Japan
   - A4: America
   - A5: Europe
   - A6: Frequency Band
   - A7: Frequency Step Width
Fig. 3
   - S1: Is Function Request Command Issued?
   - S2: Initialization of Requested Function
   - S3: Is Frequency Data Setting Necessary in Function?
   - S4: Execution of Requested Function
   - S5: Obtain Present Position Data from RAM 5
   - S6: Obtain Frequency Data from ROM 4
   - S7: Set Frequency Data to FM/AM Receiving Circuit 7
   - S8: Execution of Requested Function
   - A1: Start
   - A2: End

## Claims

1. A receiver for a mobile unit, comprising:
a memory for storing a region and a frequency band of an available radio wave of the region therein;
a present position measuring unit for measuring the present position of the mobile unit; and
a controller for detecting an area where the mobile unit is located according to the present position detected by said present position measuring unit to set a receiving frequency band of the receiver according to the detected result.

2. The receiver for a mobile unit as defined in claim 1, wherein said memory stores a frequency step width corresponding to the area where the mobile unit is located.

3. The receiver for a mobile unit as defined in claim 2, where said controller sets a frequency step width of the receiver according to the detected result. ,

4. The receiver for a mobile unit as defined in claim 1, wherein said measuring unit comprises a GPS receiver.

## Patentansprüche

1. Empfänger für eine mobile Einheit, der aufweist:
einen Speicher zum Speichern eines Bereichs und eines Frequenzbands einer verfügbaren Funkwelle des Bereichs darin;
eine Positionsmesseinheit zum Messen der momentanen Position der mobilen Einheit; und
eine Steuereinheit zum Erfassen eines Bereichs, wo die mobile Einheit angeordnet ist, entsprechend der vorliegenden Position, erfasst durch die die momentane Position messende Einheit, um ein Empfangsfrequenzband des Empfängers entsprechend dem erfassten Ergebnis einzustellen.

2. Empfänger für eine mobile Einheit, wie sie in Anspruch 1 definiert ist, wobei der Speicher eine Frequenzstufenbreite entsprechend zu dem Bereich speichert, wo die mobile Einheit angeordnet ist.

3. Empfänger für eine mobile Einheit nach Anspruch 2, wobei die Steuereinheit eine Frequenzstufenbreite des Empfängers entsprechend dem erfassten Ergebnis einstellt.

4. Empfänger für eine mobile Einheit nach Anspruch 1, wobei die Messeinheit einen GPS-Empfänger aufweist.

## Revendications

1. Récepteur pour une unité mobile, comprenant :
une mémoire pour mémoriser une région et une bande de fréquences disponible de la région, dans cette mémoire;
une unité de mesure de position actuelle pour mesurer la position actuelle de l'unité mobile; et
un contrôleur pour détecter une région, dans laquelle l'unité mobile est située conformément à la présente position détectée par ladite unité de mesure de la présente position pour régler une bande de fréquences de réception du récepteur conformément au résultat détecté.

2. Récepteur pour une unité mobile selon la revendication 1, dans lequel ladite mémoire mémorise une largeur d'échelon de fréquence correspondant à la zone, dans laquelle l'unité mobile est située.

3. Récepteur pour une unité mobile selon la revendication 2, dans lequel ledit contrôleur règle une largeur d'échelon de fréquence du récepteur conformément au résultat détecté.

4. Récepteur pour une unité mobile selon la revendication 1, dans lequel ladite unité de mesure comprend un récepteur GPS.
